# EUROPEAN PATENT APPLICATION

(11) **EP 2 282 385 A1**
(43) Date of publication of application: **09.02.2011**
(21) Application number: 10168689.7
(22) Date of filing: 07.07.2010
(51) Int. Cl.: H02B 1/38, H05K 7/18, E05B 65/40

(54) **Cabinet for electronic apparatuses having interference locking bolts for impeding disassembly of perimetral confinements panel**

(30) Priority: 09.07.2009 IT VA20090046
(71) Applicant: Tecnosteel S.r.l., 21020 Brunello (IT)
(72) Inventor: Piotti, Marino, 21044, Cavaria con Premezzo (IT)
(74) Representative: Pellegri, Alberto

(57) **Abstract**

A cabinet for electronic apparatuses and/or for structured cabling having a frame, including four uprights (2) connecting a basement or pedestal to a roof (9), to which perimetral confinement panels (3) and at least a front access door (1) hingedly sustained by one of the uprights (2) are applied, the door having a lock operable with a key and/or by remote control, has at least a locking bolt (4) including a slidable cursor (5) installed in a hole through the upright (2) to which the door is hinged and/or the upright (2) against which a lockable access door of the cabinet closes.

An end of the cursor (5) of the locking bolt protruding out of the hole across the upright (2) and interfering with an inner surface of the closed door (1) keeping, in opposition to a contrast spring (7), the cursor (5) with its other end extended out of the hole through the upright (2) and engaged in a hole, receptacle, or opening (8) of at least a perimetral confinement panel (3) adjacent thereto.

The swinging open the door (1) after unlocking the key or remotely controlled lock thereof, frees the cursor (5) of the bolt to be retracted by the contrasting spring (7) to a position of disengagement of the other end of the cursor from the hole, receptacle or opening (8) of the perimetral confinement panel (3).

## Description

### TECHNICAL REFERENCE FIELD

This invention relates to cabinet for electronic and optoelectronic apparatuses and related electrical supply and interconnection cabling, especially for "networking" and telecommunication apparatuses.

### BACKGROUND

Telecommunication and "networking" installations implemented with modem microelectronics and optoelectronics technologies require the housing of electronic and optoelectronic apparatuses inside protection structures, ergonomically studied for facilitating maintenance and service interventions, as well as an ordered organization of supply and data transmission cables.

Typically, electronic apparatuses and interconnection cabling are hosted and organized into metal cabinets with racks, means for cabling, ducting, ventilation and eventually cooling of the inner space, often specifically adapted to the need of the user.

Main station, sub-stations, signed processing centers and similar installations characterized by a great density of apparatuses, require one or many cabinets of similar or different internal organization that, from one side, must allow the easiest access to the apparatuses, cabling and interconnection devices to the operators for carrying out modifications and substitution on the single apparatuses hosted inside the cabinets or for modifying according to changed needs the cabling and from the other side they must ensure the inviolability by non authorized persons.

The cabinets comprise generally a frame structure constituted by four uprights connecting a pedestal to a roof, to which perimetral confinement panels are applied and the cabinets are normally equipped with at least a front access door hingedly sustained and having a lock operable with a key. In case of cabinets of large size there may even be a second rear door, having a lock operable with a key (normally the same of the front door). In sensible installation, a control of the accesses to the housed apparatuses may often be implemented by blocking/unblocking the locks, of the cabinets through radio-encoded command, sent from a surveillance center, the key being a manual *passepartout* to be used in emergency cases.

Commonly, for making even more simple the access to sockets and cables of the apparatuses by technicians, one or both perimetral side panels may be equipped with lifting and detachment handles for being more easily dismounted and mounted for facilitating interventions on the hosted apparatuses and/or cables. Moreover, in these cases, the access control imposes the installation of appropriate locks, generally only mechanical operable with a key, that prevent improper accesses to the apparatuses by treacherously dismounting a perimetral side panel, thus avoiding the control system that normally monitors and enables access through the front and/or rear door of the cabinet.

### SUMMARY

A particularly effective cabinet of simple realization has been found that allows an eventual dismounting and detachment of a perimetral confinement panel in a safe and easy manner after having opened the door or the doors of the cabinet that may remain a remotely monitored and controlled access to the cabinet thus avoiding a multiplication of the number of keys to be managed and eliminating the need of installing dedicated remotely controlled locks also on the removable perimetral panels.

This result is obtained in a particularly efficient way and at the same time in an extremely simple way such not to require specific maneuvers of the maintenance technician, by means of at least a locking bolt installed in a hole through the hinging and/or abutment upright of at least a door with a lock, such that an extremity of the cursor of the locking bolt protruding out of the hole across the upright interferes while the door with the lock of the cabinet is closed. In closed position, the door keeps, in opposition to a contrast spring, the cursor of the locking bolt extended out of the hole through the upright and engaged in a hole or receptacle of the adjacent perimetral confinement panel.

The swinging opening of the door after unlocking the key, frees the cursor of the locking bolt to be retracted by the contrasting spring to a position of disengagement of the end of the cursor from the hole or receptacle of the perimetral confinement panel that may be disengaged and removed for facilitating the work of technicians.

A plurality of locking bolts may be installed in as many holes through the same upright, for ensuring a greater robustness against forced disengaging displacements of the panel.

The devices may be replicated, besides through the upright to which the door is hinged also through the upright against an abutment surface of which the other end of the hinged door (in case of a single-leaf door) abuts in order to prevent forced disengaging displacements of both side confinement panels of the cabinet.

In a completely similar way, in cabinets equipped with a second rear door with similar access controlling lock alike the front door, for allowing access to the cabinet even or alternatively from the rear side, the devices for impeding disassembly of the perimetral side panels may be replicated also through the other two uprights of the frame structure of the cabinet.

If the access door with the lock is a double-leaf door, hinged respectively to two uprights, locking bolts may be installed through holes of both uprights, the cursors of which shall interfere and be acted upon one and the other of the two swinging leafs of the access door.

### BRIEF DESCRIPTION OF THE DRAWINGS

**FIGs. 1 and 2** are a partially sectioned plan view and a detail elevation view of a device for impeding disengagement and removal of side panels of a cabinet according to an embodiment of this invention.
**FIGs. 3 and 4** are similar views that show the device in a blocking position of a side panel impeding disengagement and removal of the perimetral panel.
**FIG. 5** is a schematic plant view of a cabinet for electronic apparatuses equipped with a front door with a single swinging leaf and rear access door with two swinging leafs, with means for impeding disassembly of the perimetral confinement panels according to the present invention.

The drawings have only illustrative purpose and not limitative, other embodiments of the locking bolts being possible.

### DESCRIPTION OF EXEMPLARY EMBODIMENTS

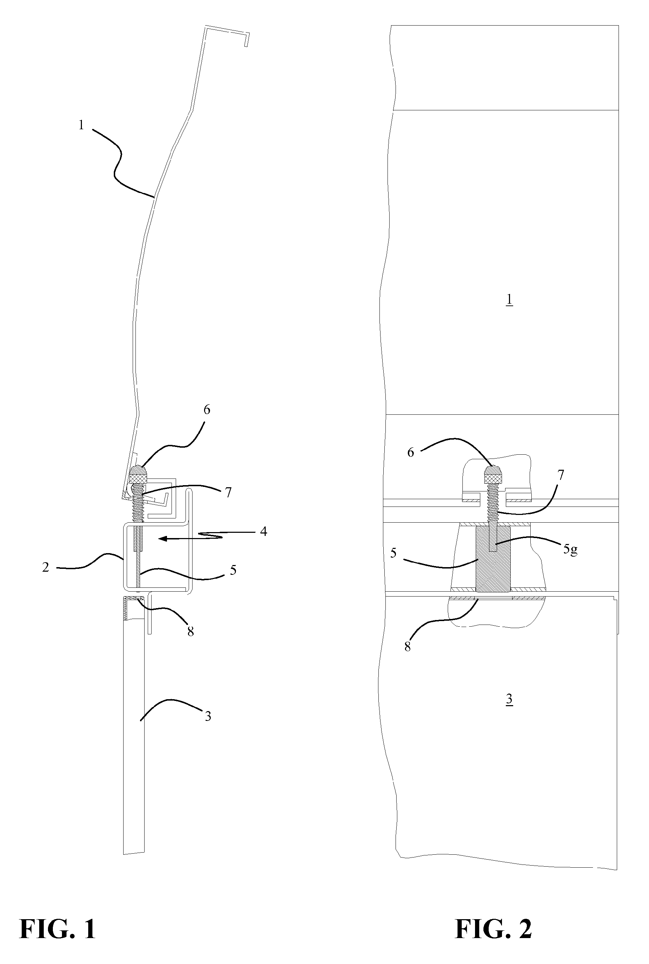

**FIG. 1** is a partial sectional plan view of a metal cabinet for housing electronic apparatuses equipped with a device of this invention.

The partial detail view shows only the upright 2 to which is hinged the swinging door 1, provided with a lock (not shown in the figures so as the hinges of the swinging wing 1, both being of any common type and virtually definable by the observer), and part of a perimetral confinement panel 3, commonly applied to a side of the frame structure of the cabinet constituted by four uprights similar to the upright 2 shown in FIG. 1.

Commonly, the side panels 3 or flanks of the cabinet generally of sheet metal, are hanged to a folded end of the sheet metal of the roof of the cabinet, by holding them vertically against the uprights of the frame and leaving them drop into a channel or any other retention seat defined in the pedestal of the cabinet, such to assume a stable anchored position onto the frame of the cabinet. This manner of assembling them facilitates their eventual disengagement and removal when installing and maintaining the apparatuses and cabling inside the cabinet. Commonly these perimetral confinement panels are equipped of dedicated handles for facilitating the operations of lifting, disengaging and temporarily removing of the panels.

The device for impeding illicit disengagement and removal of the panel 3 off the seats of stable fixing to the frame, object of this invention, is composed of a simple locking bolt indicated with 4, having a cursor 5, the end 6 of which protrudes out of a hole through the upright 2 onto which the swinging door 1 is hinged, and in the shown example, is provided with a threaded hemispheric cap 6, screwed on the threaded end of the cursor 5. The threaded cap 6 permits to establish a pre-compression of a contrast spring 7 against the outer surface of the upright 2, around the hole through which the locking bolt passes. Alternatively, the pre-compression function of the contrast spring 7 and the function of springloaded "feeler" of the cursor 5, may be satisfied also by using equivalent means such as nuts, threaded ring nuts and/or the cap 6 may be made of a low friction material. The other end of the cursor 5, the geometry of which is generally different, when retracted by the contrast spring 7 free to extend itself up to the pre-compression limit, may just cross the hole through the upright 2 without protruding much further, thus remaining disengaged from a receiving hole or opening 8 through the folded edge of the confinement panel 3.

When the door 1 is open, as may be observed in FIG. 1, the door 1 no longer interferes with the end 6 of the cursor of the locking bolt and the perimetral confinement panel 3 is free to be disengaged and removed from the frame, for example by lifting it as much as necessary for freeing it from the hanging channel at the top (in the roof) and from the retaining channel at the bottom (on the pedestal) and thus be completely removed for permitting a free side way access to the hosted apparatuses.
**FIG. 2** is a sectional view that shows the exemplary conformation of the cursor-locking bolt and in particular of its end 5 locking/unlocking in a slit opening 8 in the bent side edge of the panel 3. In the shown example the end 5 of the cursor is a plate welded to a steel rod stem.

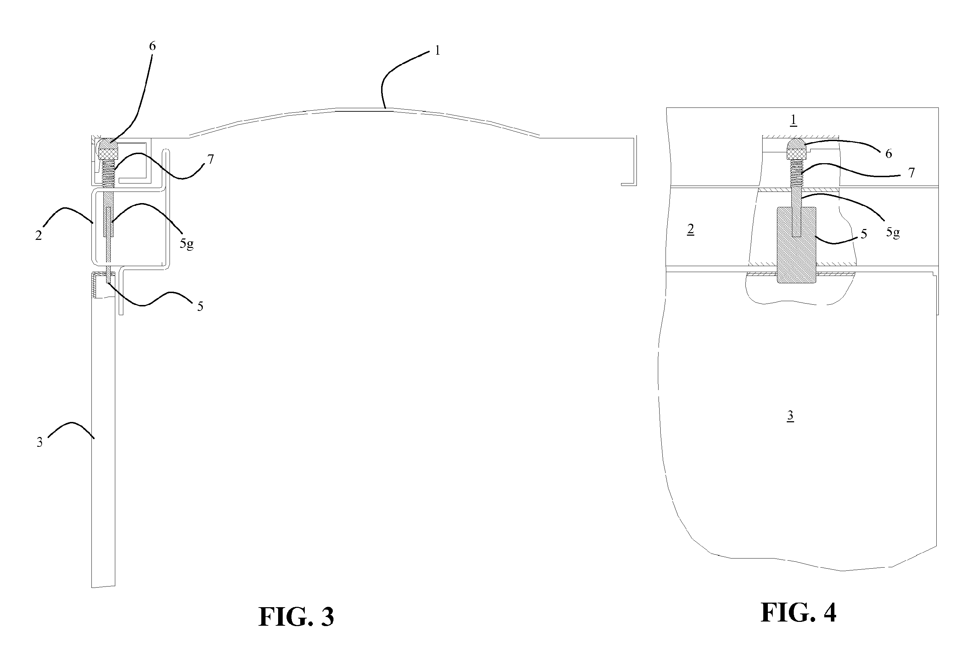

**FIGs. 3 and 4** are similar views that show the device when the door 1 is completely closed and eventually locked by the safety lock.

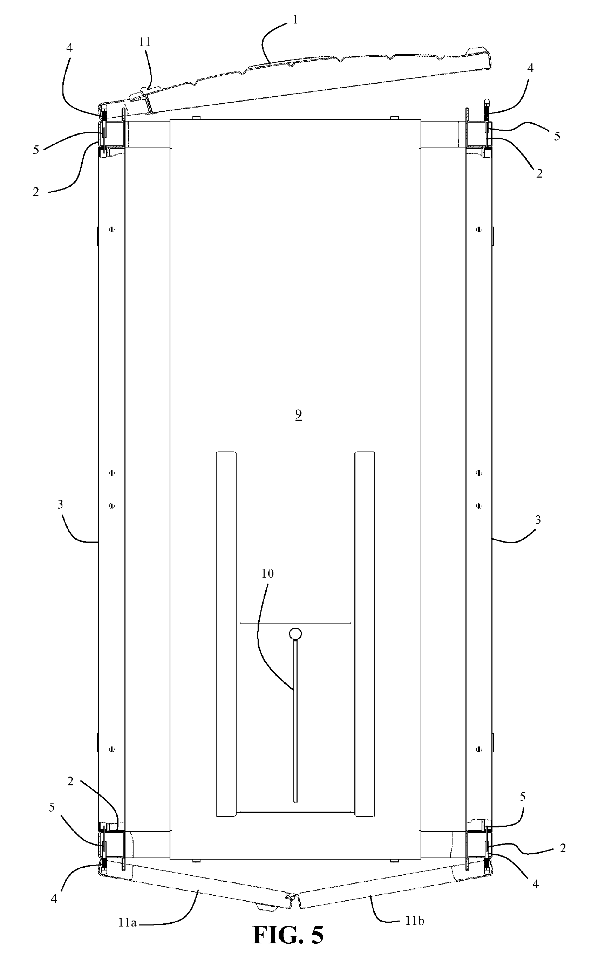

**FIG. 5** is a top view of a cabinet comprising a common frame composed of four uprights 2, connecting them a pedestal or basement (non observable in the figure) to a roof 9 that, in the shown example, has a cable-clamp slit device 10. The illustrated cabinet has a front door 1 with a single swinging leaf, that in the shown example has a hinge joint 11 for completely opening the door 1 even in case the side of the cabinet is placed near to a wall or to another cabinet (as disclosed in prior Italian utility model application No. VA 2009U000011 in the name of the same applicant).

The exemplary cabinet of relatively large size, contemplates also the presence of a door with two swinging leafs 11a and 11b, for accessing the cabinet from the rear, hinged respectively to the two rear uprights 2 of the frame of the cabinet.

The perimetral confinement is competed by the two side panels or flanks 3, commonly made of metal sheet and applicable to the frame in the above described way or in any case such to allow, when needed or appropriate, to be easily disengaged and removed temporarily for facilitating work inside the cabinet.

As may be observed from the sectional view in correspondence of the four uprights 2 of the frame-structure of the cabinet, interference locking bolts of identical or similar structure in functional terms to that described in the previous figures, ensure an impossibility of displacing and disassembling the side panels 3 without previously opening the front door and the double-leaf rear door, both provided with safety locks that may thus implement a reliable control of accesses to the apparatuses hosted in the cabinet.

The important simplification and effectiveness of controlled accesses ensured by the device of the present invention may be implemented with any number of interference locking bolts even different through functionally equivalent to the ones exemplarily illustrated in the drawings.

## Claims

1. A cabinet for electronic apparatuses and/or for structured cabling having a frame, including four uprights (2) connecting a basement or pedestal to a roof (9), to which perimetral confinement panels (3) and at least a front access door (1) hingedly sustained by one of said uprights (2) are applied, said door having a lock operable with a key and/or by remote control, and means adapted to impede disassembly and removal of said perimetral confinement panels (3) without the opening of said access door, **characterized in that** said means comprise
at least a locking bolt (4) including a slidable cursor (5) installed in a hole through the upright (2) to which the door is hinged and/or the upright (2) against which a lockable access door of the cabinet closes;
an end of a cursor (5) of the locking bolt protruding out of said hole across said upright (2) and interfering with an inner surface of the closed door (1) keeping, in opposition to a contrast spring (7), said cursor (5) with its other end extended out of the hole through the upright (2) and engaged in a hole, receptacle, or opening (8) of at least a perimetral confinement panel (3) adjacent thereto;
swinging open the door (1) after unlocking the key or remotely controlled lock thereof, frees the cursor (5) of the bolt to be retracted by said contrasting spring (7) to a position of disengagement of said other end of the cursor from said hole, receptacle or opening (8) of said perimetral confinement panel (3).

2. The cabinet according to claim 1, wherein upon closing it, the access door (1) interferes with a plurality of locking bolts (4) installed in spaced holes through the same upright (2).

3. The cabinet according to claim 1, having a front access door (1) and a rear access door, both interfering respectively with at least a locking bolt (4) of a confinement panel (3) adjacent thereto.

4. The cabinet according to claim 1, wherein each key or remotely lockable access door (1) interferes upon closing it with at least a locking bolt (4) having a cursor (5) crossing the upright (2) on the hinged side of the door (1) for blocking the perimetral confinement panel (3) adjacent to the same upright, and with at least another locking bolt (4) having a cursor (5) crossing the upright (2) against which the door closes, for blocking another perimetral confinement panel (3) adjacent to the latter upright (2).

5. The cabinet according to claim 1, wherein the lockable door (1) is composed by two complementary wings (11a, 11b) respectively hinged to two uprights (2) through holes of which are installed locking bolts (4) the cursors (5) of which interfere with one and with the other of said two swinging wings (11a, 11b), respectively.
